# EUROPEAN PATENT APPLICATION

(11) **EP 4 503 898 A1**
(43) Date of publication of application: **05.02.2025**
(21) Application number: 24171973.1
(22) Date of filing: 23.04.2024
(51) Int. Cl.: H10K 59/80, H10K 50/844, H10K 50/858

(54) **DISPLAY APPARATUS AND METHOD OF MANUFACTURING THE SAME**

(30) Priority: 01.08.2023 KR 20230100700
(71) Applicant: Samsung Display Co., Ltd., Yongin-si, Gyeonggi-do 17113 (KR)
(72) Inventor: GONG, Donghyun, 17113 Yongin-si (KR); KIM, Moonsung, 17113 Yongin-si (KR); PARK, Junsu, 17113 Yongin-si (KR); SEO, Hyunsang, 17113 Yongin-si (KR); HAN, Seokkyu, 17113 Yongin-si (KR)
(74) Representative: Marks & Clerk LLP

(57) **Abstract**

A display apparatus includes a substrate, an organic light-emitting device disposed over the substrate, a first inorganic encapsulation layer covering the organic light-emitting device, an organic encapsulation layer on the first inorganic encapsulation layer, a second inorganic encapsulation layer on the organic encapsulation layer, and a third inorganic encapsulation layer on the second inorganic encapsulation layer, wherein the third inorganic encapsulation layer is thicker than the second inorganic encapsulation layer, and the second inorganic encapsulation layer has a thickness of about 400 Å to about 1800 Å.

## Description

### BACKGROUND

### 1. Field

One or more embodiments relate to a display apparatus and a method of manufacturing the same, and more particularly, to a display apparatus with a low defect rate during a manufacturing process and a method of manufacturing the same.

### 2. Description of the Related Art

In general, a display apparatus includes a pixel circuit that controls whether each pixel emits light and the degree of light emission, and a display device that is electrically connected to the pixel circuit. Additionally, in order to protect display devices from external impurities, the display apparatus may include an encapsulation layer covering a display area.

### SUMMARY

However, in the existing display apparatus, a display device may be damaged due to outgas generated from an organic encapsulation layer during a manufacturing process, resulting in a defective display apparatus.

One or more embodiments include a display apparatus with a low defect rate during a manufacturing process and a method of manufacturing the display apparatus. Embodiments set forth herein are examples, and the scope of the disclosure is not limited thereby.

Additional aspects will be set forth in part in the description which follows and, in part, will be apparent from the description, or may be learned by practice of the presented embodiments of the disclosure.

According to one or more embodiments, a display apparatus includes a substrate, an organic light-emitting device disposed over the substrate, a first inorganic encapsulation layer covering the organic light-emitting device, an organic encapsulation layer on the first inorganic encapsulation layer, a second inorganic encapsulation layer on the organic encapsulation layer, and a third inorganic encapsulation layer on the second inorganic encapsulation layer, wherein the third inorganic encapsulation layer is thicker than the second inorganic encapsulation layer, and the second inorganic encapsulation layer has a thickness of about 400 Å to about 1800 Å.

A sum of a thickness of the second inorganic encapsulation layer and a thickness of the third inorganic encapsulation layer may be about 4000 Å to about 6000 Å.

The second inorganic encapsulation layer may have a thickness of about 800 Å to about 1500 Å.

The second inorganic encapsulation layer may have a thickness of about 1000 Å to about 1200 Å.

The first inorganic encapsulation layer may include silicon oxynitride, the second inorganic encapsulation layer may include silicon oxynitride, and the third inorganic encapsulation layer may include silicon nitride.

An average content of oxygen atoms in the entire second inorganic encapsulation layer may be about 5.0 atomic percent (at%) to about 7.0 atomic percent (at%).

A refractive index of the second inorganic encapsulation layer may be about 1.86 to about 1.89.

A refractive index of the third inorganic encapsulation layer may be greater than the refractive index of the second inorganic encapsulation layer.

An average content of oxygen atoms in the entire first inorganic encapsulation layer may be higher than an average content of oxygen atoms in the entire second inorganic encapsulation layer.

The first inorganic encapsulation layer may include a 1st-1st inorganic encapsulation layer covering the organic light-emitting device and including silicon oxynitride, and a 1st-2nd inorganic encapsulation layer disposed on the 1st-1st inorganic encapsulation layer and including silicon oxynitride, wherein an average content of oxygen atoms in the entire 1st-2nd inorganic encapsulation layer may be higher than an average content of oxygen atoms in the entire 1st-1st inorganic encapsulation layer.

The 1st-2nd inorganic encapsulation layer may be thinner than the 1st-1st inorganic encapsulation layer.

According to one or more embodiments, a method of manufacturing a display apparatus includes forming an organic light-emitting device over a substrate, forming a first inorganic encapsulation layer covering the organic light-emitting device, forming an organic encapsulation layer on the first inorganic encapsulation layer, forming a second inorganic encapsulation layer with a thickness of about 400 Å to about 1800 Å on the organic encapsulation layer, and forming a third inorganic encapsulation layer on the second inorganic encapsulation layer, the third inorganic encapsulation layer being thicker than the second inorganic encapsulation layer.

The method may further include, between the forming of the organic encapsulation layer and the forming of the second inorganic encapsulation layer, surface-treating an upper surface of the organic encapsulation layer by using plasma.

The forming of the third inorganic encapsulation layer may include forming the third inorganic encapsulation layer so that the sum of a thickness of the second inorganic encapsulation layer and a thickness of the third inorganic encapsulation layer is about 4000 Å to about 6000 Å.

The forming of the second inorganic encapsulation layer may include forming the second inorganic encapsulation layer to a thickness of about 800 Å to about 1500 Å.

The forming of the second inorganic encapsulation layer may include forming the second inorganic encapsulation layer to a thickness of about 1000 Å to about 1200 Å.

The forming of the first inorganic encapsulation layer may include forming an inorganic encapsulation layer including silicon oxynitride, the forming of the second inorganic encapsulation layer may include forming an inorganic encapsulation layer using reaction gases which do not include an oxygen source, and the forming of the third inorganic encapsulation layer may include forming an inorganic encapsulation layer including silicon nitride.

An average content of oxygen atoms in the entire second inorganic encapsulation layer may be about 5.0 atomic percent (at%) to about 7.0 atomic percent (at%).

A refractive index of the second inorganic encapsulation layer may be about 1.86 to about 1.89.

A refractive index of the third inorganic encapsulation layer may be greater than the refractive index of the second inorganic encapsulation layer.

An average content of oxygen atoms in the entire first inorganic encapsulation layer may be higher than an average content of oxygen atoms in the entire second inorganic encapsulation layer.

The forming of the first inorganic encapsulation layer may include forming a 1st-1st inorganic encapsulation layer including silicon oxynitride to cover the organic light-emitting device, and forming a 1st-2nd inorganic encapsulation layer including silicon oxynitride on the 1st-1st inorganic encapsulation layer, wherein an average content of oxygen atoms in the entire 1st-2nd inorganic encapsulation layer may be higher than an average content of oxygen atoms in the entire 1st-1st inorganic encapsulation layer.

The 1st-2nd inorganic encapsulation layer may be thinner than the 1st-1st inorganic encapsulation layer.

At least some of the above and other features of the invention are set out in the claims.

Other aspects, features, and advantages than the above-described aspects, features, and advantages will be apparent from a detailed description, the claims, and the drawings.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic cross-sectional view showing a display apparatus according to an embodiment;
FIG. 2 is a schematic conceptual diagram showing a portion of the display apparatus of FIG. 1;
FIGS. 3, 4 and 5 are schematic cross-sectional views showing a process of manufacturing the display apparatus of FIG. 1; and
FIG. 6 is a schematic cross-sectional view showing a display apparatus according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

Various modifications may be applied to the present embodiments, and particular embodiments will be illustrated in the drawings and described in the detailed description section. The effect and features of the present embodiments, and a method to achieve the same, will be clearer referring to the detailed descriptions below with the drawings. However, the present embodiments may be implemented in various forms, not by being limited to the embodiments presented below.

Hereinafter, embodiments will be described in detail with reference to the accompanying drawings, and in the description with reference to the drawings, the same or corresponding constituents are indicated by the same reference numerals and redundant descriptions thereof are omitted.

It will be understood that when a component, such as a layer, a film, a region, or a plate, is referred to as being "on" another component, the component may be directly on the other component or intervening components may be present therebetween. Sizes of components in the drawings may be exaggerated for convenience of explanation. For example, since sizes and thicknesses of components in the drawings are arbitrarily illustrated for convenience of explanation, the following embodiments are not limited thereto.

The x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

In the following embodiment, it will be understood that although the terms "first," "second," etc. may be used herein to describe various components, these components should not be limited by these terms. These terms are only used to distinguish one component from another.

In the following embodiment, it will be further understood that the terms "include", "comprise", and/or "have" used herein specify the presence of stated features or components, but do not preclude the presence or addition of one or more other features or components.

In the specification, the expression such as "A and/or B" may include A, B, or A and B. Furthermore, the expression such as "at least one of A and B" may include A, B, or A and B.

In the following embodiments, when layers, regions, or components are connected to each other, the layers, the regions, or the components may be directly connected to each other, or another layer, another region, or another component may be interposed between the layers, the regions, or the components and thus the layers, the regions, or the components may be indirectly connected to each other. For example, in the following embodiments, when layers, regions, or components are electrically connected to each other, the layers, the regions, or the components may be directly electrically connected to each other, or another layer, another region, or another component may be interposed between the layers, the regions, or the components and thus the layers, the regions, or the components may be indirectly electrically connected to each other.

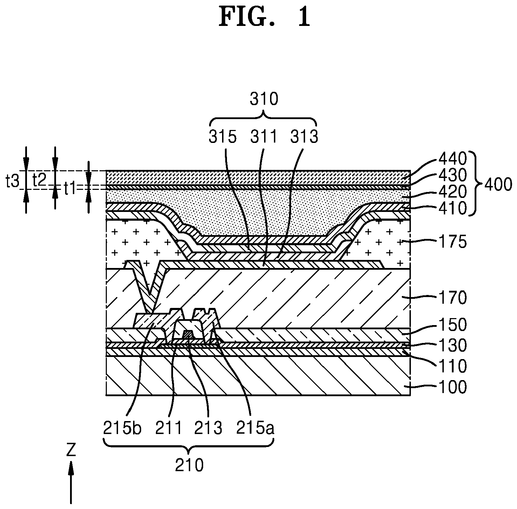

FIG. 1 is a schematic cross-sectional view showing a display apparatus according to an embodiment. The display apparatus according to the present embodiment may include a substrate 100, a thin-film transistor 210, an organic light-emitting device 310, which is a display device, disposed over the substrate 100, and an encapsulation layer 400 covering the organic light-emitting device 310.

The substrate 100 may include various materials that are flexible or bendable. For example, the substrate 100 may include a polymer resin such as polyethersulfone (PES), polyacrylate, polyetherimide (PEI), polyethylene naphthalate (PEN), polyethylene terephthalate (PET), polyphenylene sulfide (PPS), polyarylate (PAR), polyimide (PI), polycarbonate (PC), or cellulose acetate propionate (CAP). However, the substrate 100 may have a multi-layered structure including two layers and a barrier layer disposed therebetween, each of the two layers may include polymer resin, and the barrier layer may include an inorganic material such as silicon oxide, silicon nitride, and silicon oxynitride, and various modifications may be made. Furthermore, when the substrate 100 is not bent, the substrate 100 may include glass or the like.

As shown in FIG. 1, the thin-film transistor 210 includes a semiconductor layer 211 including amorphous silicon, polycrystalline silicon, or an organic semiconductor material, a gate electrode 213, a source electrode 215a, and a drain electrode 215b. Although it is shown in FIG. 1 that the thin-film transistor 210 includes the source electrode 215a and the drain electrode 215b, the disclosure is not limited thereto. For example, the source electrode 215a and/or the drain electrode 215b may be part of a wiring line. Alternatively, the thin-film transistor 210 may not have the source electrode 215a and/or the drain electrode 215b, and a source region of the semiconductor layer 211 may serve as a source electrode and/or a drain region of the semiconductor layer 211 may serve as a drain electrode. For example, the source region of the semiconductor layer 211 of the thin-film transistor 210 may be integral with a drain region of another thin-film transistor as a single body. In this case, it may be understood that the drain electrode of the other thin film transistor is electrically connected to the source electrode of the thin film transistor 210.

In order to ensure insulation between the semiconductor layer 211 and the gate electrode 213, a gate insulating layer 130 including an inorganic material such as silicon oxide, silicon nitride, and/or silicon oxynitride may be disposed between the semiconductor layer 211 and the gate electrode 213. In addition, an interlayer insulating layer 150 including an inorganic material such as silicon oxide, silicon nitride, and/or silicon oxynitride may be disposed on the gate electrode 213, and the source electrode 215a and the drain electrode 215b may be disposed on the interlayer insulating layer 150. Insulating layers including an inorganic material may be formed through chemical vapor deposition (CVD) or atomic layer deposition (ALD). This also applies to embodiments described below and modifications thereof.

A buffer layer 110 including an inorganic material such as silicon oxide, silicon nitride, and/or silicon oxynitride may be disposed between the thin-film transistor 210 and the substrate 100. This buffer layer 110 may increase the smoothness of the upper surface of the substrate 100 or prevent or reduce the penetration of impurities from the substrate 100 into the semiconductor layer 211 of the thin-film transistor 210.

The gate electrode 213 may include a metal such as molybdenum or aluminium and may be formed by a method such as sputtering. The gate electrode 213 may have a single-layered structure or a multi-layered structure. For example, the gate electrode 213 may have a two-layered structure including molybdenum/aluminium layers.

The source electrode 215a and the drain electrode 215b may include metal such as titanium or aluminium and may have a single-layered or multi-layered structure. For example, each of the source electrode 215a and the drain electrode 215b may have a three-layered structure including titanium/aluminium/titanium layers.

A planarization layer 170 may be disposed on the thin-film transistor 210. For example, when the organic light-emitting device 310 is disposed above the thin-film transistor 210 as shown in FIG. 1, the planarization layer 170 may substantially planarize an upper portion of the thin-film transistor 210. The planarization layer 170 may include an organic material such as acrylic, benzocyclobutene (BCB), or hexamethyldisiloxane (HMDSO). Although it is shown in FIG. 1 that the planarization layer 170 is a single layer, various modifications may be made. For example, the planarization layer 170 may have a multi-layered structure.

In a display area of the substrate 100, a display device may be disposed on the planarization layer 170. The display device may be, for example, an organic light-emitting device 310 having a pixel electrode 311, an opposite electrode 315, and an intermediate layer 313 disposed therebetween and including an emission layer.

The organic light-emitting device 310 may be disposed over the substrate 100 and a pixel circuit that is electrically connected to the organic light-emitting device 310 and controls the degree of light emission may be disposed between the substrate 100 and the organic light-emitting device 310.

The pixel electrode 311 is electrically connected to the thin-film transistor 210 by contacting either the source electrode 215a or the drain electrode 215b through an opening formed in the planarization layer 170, etc., as shown in FIG. 1. The pixel electrode 311 may include a light-transmitting conductive layer including a light-transmitting conductive oxide such as ITO, In₂O₃, or IZO, and a reflective layer including a metal such as Al or Ag. For example, the pixel electrode 311 may have a three-layered structure including ITO/Ag/ITO layers.

A pixel-defining layer 175 may be disposed on the pixel electrode 311 on the planarization layer 170. The pixel-defining layer 175 has an opening corresponding to each subpixel, that is, an opening that exposes at least a central portion of the pixel electrode 311, and thus serves to define a pixel. In addition, in the case shown in FIG. 1, the pixel-defining layer 175 may prevent an arc or the like from occurring at the edge of the pixel electrode 311 by increasing a distance between the edge of the pixel electrode 311 and the opposite electrode 315 disposed above the pixel electrode 311. The pixel-defining layer 175 may include an organic material such as polyimide or HMDSO.

The intermediate layer 313 of the organic light-emitting device 310 may include a low-molecular weight or high-molecular weight material. When the intermediate layer 313 includes a low-molecular weight material, the intermediate layer 313 may have a structure in which a hole injection layer (HIL), a hole transport layer (HTL), an emission layer (EML), an electron transport layer (ETL), an electron injection layer (EIL), etc. are stacked in a single or complex structure, and may be formed by vacuum deposition. When the intermediate layer 313 includes a high-molecular weight material, the intermediate layer 313 may have a structure including an HTL and an EML. In this case, the HTL may include PEDOT, and the EML may include a polymer material such as a poly-phenylenevinylene (PPV)-based material or a polyfluorene-based material. The intermediate layer 313 may be formed by screen printing, inkjet printing, laser induced thermal imaging (LITI), or the like.

However, the intermediate layer 313 is not necessarily limited thereto and may have various structures. In addition, each of the layers other than the EML of the intermediate layer 313 may be integrally formed as a single body over a plurality of pixel electrodes 311. The EML may be formed to correspond to each of the plurality of pixel electrodes 311.

The opposite electrode 315 is disposed above the display area, and may be arranged to cover the display area. That is, the opposite electrode 315 may be integrally formed as one body with respect to a plurality of organic light-emitting devices 310 and may overlap the plurality of pixel electrodes 311 in a plan view. The opposite electrode 315 may include a light-transmitting conductive layer including ITO, In₂O₃, or IZO and may also include a semi-transmissive layer including a metal such as Al or Ag. For example, the opposite electrode 315 may include a semi-transmissive layer including MgAg.

Because the organic light-emitting device 310 may be easily damaged by moisture or oxygen from the outside, the encapsulation layer 400 may cover the organic light-emitting device 310 to protect the organic light-emitting device 310. The encapsulation layer 400 may cover the display area and may extend to at least a portion of a peripheral area. The encapsulation layer 400 includes a first inorganic encapsulation layer 410, an organic encapsulation layer 420, a second inorganic encapsulation layer 430, and a third inorganic encapsulation layer 440 sequentially disposed on the organic light-emitting device 310.

The first inorganic encapsulation layer 410 formed by chemical vapor deposition may cover the organic light-emitting device 310. This first inorganic encapsulation layer 410 may include silicon oxynitride. The first inorganic encapsulation layer 410 has a lower ability to prevent penetration of moisture, etc., than the third inorganic encapsulation layer 440, which will be described later, but has a refractive index lower than that of the third inorganic encapsulation layer 440, and thus, the extraction rate of light emitted from the organic light-emitting device 310 to the outside may be increased.

The organic encapsulation layer 420 may include a polymer-based material. Examples of the polymer-based material may include silicone-based resins, acrylic resins (e.g., polymethyl methacrylate, polyacrylic acid, etc.), epoxy-based resins, polyimide, and polyethylene. In a manufacturing process, a monomer for forming the organic encapsulation layer 420 may be placed on the first inorganic encapsulation layer 410, and then ultraviolet rays, etc. may be irradiated to the monomer to form a polymer.

As the first inorganic encapsulation layer 410 formed by chemical vapor deposition has an approximately uniform thickness, the upper surface of the first inorganic encapsulation layer 410 may have an uneven surface which corresponds to a contour of structures disposed below the first inorganic encapsulation layer 410, as shown in FIG. 1. Therefore, the upper surface of the first inorganic encapsulation layer 410 is not flat. However, the organic encapsulation layer 420 has a substantially flat upper surface, and accordingly, the second inorganic encapsulation layer 430 disposed on the organic encapsulation layer 420 may also have a substantially flat upper surface.

The second inorganic encapsulation layer 430 is disposed on the organic encapsulation layer 420 and may include silicon oxynitride. The third inorganic encapsulation layer 440 disposed on the second inorganic encapsulation layer 430 may include silicon nitride. The second inorganic encapsulation layer 430 and the third inorganic encapsulation layer 440 may be formed by chemical vapor deposition. However, process conditions of the chemical vapor deposition when forming the second inorganic encapsulation layer 430 may be different from process conditions of the chemical vapor deposition when forming the third inorganic encapsulation layer 440. This will be described later.

The third inorganic encapsulation layer 440 including silicon nitride has an excellent ability to prevent moisture infiltration from the outside. Therefore, it is possible to effectively prevent moisture from the outside from passing through the encapsulation layer 400 and reaching the organic light-emitting device 310.

Before forming the second inorganic encapsulation layer 430, the upper surface of the organic encapsulation layer 420 may be plasma-treated. This may be understood as ashing the upper surface of the organic encapsulation layer 420. Through the surface treatment, impurities on the upper surface of the organic encapsulation layer 420 may be removed, and the surface of the organic encapsulation layer 420 may be reformed. Through the reformation, the surface of the organic encapsulation layer 420 may be changed from hydrophobic to hydrophilic, and thus, when forming the second inorganic encapsulation layer 430 later, a bonding force between the organic encapsulation layer 420 and the second inorganic encapsulation layer 430 may be increased to facilitate the formation of the second inorganic encapsulation layer 430.

In the process of surface-treating the organic encapsulation layer 420 in this way, moisture or the like within the organic encapsulation layer 420 may be located on or near the surface of the organic encapsulation layer 420. In addition, because the process temperature when forming the third inorganic encapsulation layer 440 later is high, moisture in the organic encapsulation layer 420 may move to the outside (outgas) even during the process of forming the third inorganic encapsulation layer 440. In addition, outgas may be generated from the organic encapsulation layer 420 during a heat treatment process for reliability evaluation after manufacturing the display apparatus.

The first inorganic encapsulation layer 410 is formed by chemical vapor deposition, as described above. When impurities such as particles are present on the organic light-emitting device 310 when forming the first inorganic encapsulation layer 410, the first inorganic encapsulation layer 410 may not completely cover the particles. In this case, as a result, pin holes corresponding to the position of the particles may be formed in the first inorganic encapsulation layer 410. Therefore, when outgas is generated in the organic encapsulation layer 420 as described above, the outgas may move to the organic light-emitting device 310 disposed below through the pin holes in the first inorganic encapsulation layer 410, and thus, defects such as the organic light-emitting device 310 not being able to properly emit light may occur.

In the case of the display apparatus according to the present embodiment, in order to prevent such problems from occurring, a thickness t1 of the second inorganic encapsulation layer 430 is set to be about 400 Å to about 1800 Å. The total amount of outgas generated in the organic encapsulation layer 420 is approximately fixed, and the outgas basically tends to move upward, that is, toward the second inorganic encapsulation layer 430. Therefore, when the outgas is completely absorbed by the second inorganic encapsulation layer 430, even though pin holes exist in the first inorganic encapsulation layer 410, it is possible to prevent the outgas from affecting the organic light-emitting device 310 under the first inorganic encapsulation layer 410 or to effectively reduce the effect of the outgas. To this end, the thickness t1 of the second inorganic encapsulation layer 430 is 400 Å or more. When the thickness t1 of the second inorganic encapsulation layer 430 is less than 400 Å, the moisture absorption ability of the second inorganic encapsulation layer 430 may decrease, and thus, most of the outgas generated from the organic encapsulation layer 420 during the manufacturing process may not be absorbed into the second inorganic encapsulation layer 430.

The sum t3 of the thickness t1 of the second inorganic encapsulation layer 430 and the thickness t2 of the third inorganic encapsulation layer 440 may be fixed. When the sum t3 of the thickness t1 of the second inorganic encapsulation layer 430 and the thickness t2 of the third inorganic encapsulation layer 440 excessively increases, the extraction rate of light emitted from the organic light-emitting device 310 to the outside may be reduced. The sum t3 of the thickness t1 of the second inorganic encapsulation layer 430 and the thickness t2 of the third inorganic encapsulation layer 440 may be set to 5000 Å, and considering a tolerance of approximately 1000 Å, the sum t3 of the thickness t1 of the second inorganic encapsulation layer 430 and the thickness t2 of the third inorganic encapsulation layer 440 may be set to be about 4000 Å to about 6000 Å.

In this case, the third inorganic encapsulation layer 440 is thicker than the second inorganic encapsulation layer 430. The third inorganic encapsulation layer 440 serves to prevent impurities, such as moisture from the outside, from penetrating into the organic light-emitting device 310, and when the third inorganic encapsulation layer 440 is thinner than the second inorganic encapsulation layer 430, such moisture-proofing ability may not be guaranteed. Specifically, the ratio between the thickness t1 of the second inorganic encapsulation layer 430 and the thickness t2 of the third inorganic encapsulation layer 440 may be 1:9 to 3:7. When the thickness t1 of the second inorganic encapsulation layer 430 exceeds 3/10 of the sum t3 of the thickness t1 of the second inorganic encapsulation layer 430 and the thickness t2 of the third inorganic encapsulation layer 440, the thickness t2 of the third inorganic encapsulation layer 440, which prevents moisture from penetrating from the outside, may be reduced, and thus, the moisture-proofing ability of the encapsulation layer 400 may decrease. Accordingly, when the sum t3 of the thickness t1 of the second inorganic encapsulation layer 430 and the thickness t2 of the third inorganic encapsulation layer 440 is 6000 Å, the maximum value of the thickness t1 of the second inorganic encapsulation layer 430 may be 1800 Å, which is 3/10 of 6000 Å. Therefore, the thickness t1 of the second inorganic encapsulation layer 430 is about 400 Å to about 1800 Å.

As described above, the first inorganic encapsulation layer 410 may include silicon oxynitride, and thus, the light extraction rate, which is the rate at which light from the organic light-emitting device 310 is extracted to the outside, may be above an appropriate level. This also applies to the second inorganic encapsulation layer 430. By ensuring that the refractive index of the second inorganic encapsulation layer 430 is less than or equal to the refractive index of the third inorganic encapsulation layer 440, the light extraction rate, which is the rate at which light from the organic light-emitting device 310 is extracted to the outside, may be above an appropriate level. Because the refractive index of the third inorganic encapsulation layer 440 including silicon nitride is about 1.89 to about 2.00, it is necessary to ensure that the refractive index of the second inorganic encapsulation layer 430 is about 1.86 to about 1.89. To this end, the thickness t1 of the second inorganic encapsulation layer 430 may be set to be about 800 Å to about 1500 Å. Light of wavelength of 555 nm may be used to determine the refractive index. This also applies to embodiments described below and modifications thereof.

Through experiments, it was confirmed that there was no substantial difference between the moisture absorption amount of the second inorganic encapsulation layer 430 when the thickness of the second inorganic encapsulation layer 430 is 800 Å and the moisture absorption amount of the second inorganic encapsulation layer 430 when the thickness of the second inorganic encapsulation layer 430 is 1000 Å. Considering this, the thickness t1 of the second inorganic encapsulation layer 430 may be set to 1000 Å or more. As described above, the sum t3 of the thickness t1 of the second inorganic encapsulation layer 430 and the thickness t2 of the third inorganic encapsulation layer 440 may be 4000 Å. In this case, the maximum value of the thickness t1 of the second inorganic encapsulation layer 430 may be 1200 Å, which corresponds to 3/10 of the sum t3 of the thickness t1 of the second inorganic encapsulation layer 430 and the thickness t2 of the third inorganic encapsulation layer 440. Therefore, the thickness t1 of the second inorganic encapsulation layer 430 may be about 1000 Å to about 1200 Å.

When forming the first inorganic encapsulation layer 410 by using chemical vapor deposition, the first inorganic encapsulation layer 410 including silicon oxynitride is formed using reaction gases, for example, SiH₄ gas, N₂O gas and NH₃ gas. In contrast, when forming the second inorganic encapsulation layer 430 by using chemical vapor deposition, the reaction gases may be reaction gases for example, SiCl₄ gas and NH₃ gas, which are the same reaction gases forming the silicon nitride. In this case, oxygen contained in the outgas from the organic encapsulation layer 420 may be included in the second inorganic encapsulation layer 430, and as a result, the second inorganic encapsulation layer 430 becomes silicon oxynitride not silicon nitride. Accordingly, the average content of oxygen atoms in the entire second inorganic encapsulation layer 430 may be less than the average content of oxygen atoms in the entire first inorganic encapsulation layer 410. The average content of oxygen atoms in the entire second inorganic encapsulation layer 430 formed in this way may be about 5.0 atomic percent (at%) or about 7.0 atomic percent (at%). An average content of oxygen atoms in a layer can be determined by using TEM EDS (transmission electron microscope energy dispersive spectrometer). This also applies to embodiments described below and modifications thereof.

For reference, within the second inorganic encapsulation layer 430, the oxygen atom content may vary depending on the location. Therefore, it is desirable to consider the average content of oxygen atoms in the entire second inorganic encapsulation layer 430, rather than the oxygen atom content at a certain position in the second inorganic encapsulation layer 430.

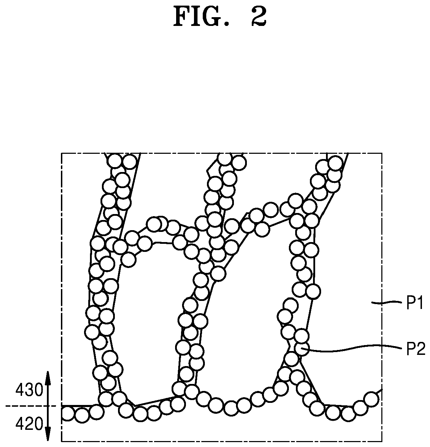

FIG. 2 is a schematic conceptual diagram showing a portion of the display apparatus of FIG. 1. Specifically, FIG. 2 schematically shows a portion of the second inorganic encapsulation layer 430 disposed on the organic encapsulation layer 420. As shown in FIG. 2, pin holes are formed in the second inorganic encapsulation layer 430, and the pin holes are formed by oxygen atoms P2 emitted from the organic encapsulation layer 420.

As described above, when forming the second inorganic encapsulation layer 430 by using chemical vapor deposition, reaction gases are the same reaction gases for forming silicon nitride. In the process of forming the second inorganic encapsulation layer 430, oxygen contained in outgas from the organic encapsulation layer 420 may be included in the second inorganic encapsulation layer 430 to form an oxynitride. Accordingly, as shown in FIG. 2, the oxygen atoms P2 cause fine pin holes in the second inorganic encapsulation layer 430, and thus, an empty space is formed between lumps P1 included in the second inorganic encapsulation layer 430.

Therefore, even though outgas is generated from the organic encapsulation layer 420 due to the high temperature process of forming the third inorganic encapsulation layer 440 or the high temperature environment during the reliability evaluation process of the display apparatus later, the outgas may move into pin holes included in the second inorganic encapsulation layer 430 and be absorbed by the second inorganic encapsulation layer 430. Accordingly, a defect occurrence rate during the process of manufacturing the display apparatus may be dramatically reduced.

The second inorganic encapsulation layer 430 which includes pin holes may be a porous structure. However, when the porosity of the second inorganic encapsulation layer 430 is excessively high, the outgas generated in the organic encapsulation layer 420 may not be captured by the second inorganic encapsulation layer 430 and may move back to the organic encapsulation layer 420 and exist within the organic encapsulation layer 420. In this case, at least a portion of the outgas present in the organic encapsulation layer 420 may move to the organic light-emitting device 310, causing defects in the organic light-emitting device 310. Therefore, considering this, the average content of oxygen atoms in the entire second inorganic encapsulation layer 430 may be set to 7.0 atomic percent (at%) or less.

As described above, the maximum value of the thickness t1 of the second inorganic encapsulation layer 430 may be 1800 Å. In this case, the average content of oxygen atoms in the entire second inorganic encapsulation layer 430 may be lowered to 5.0 atomic percent (at%). Therefore, the average content of oxygen atoms in the entire second inorganic encapsulation layer 430 may be about 5.0 atomic percent (at%) to about 7.0 atomic percent (at%).

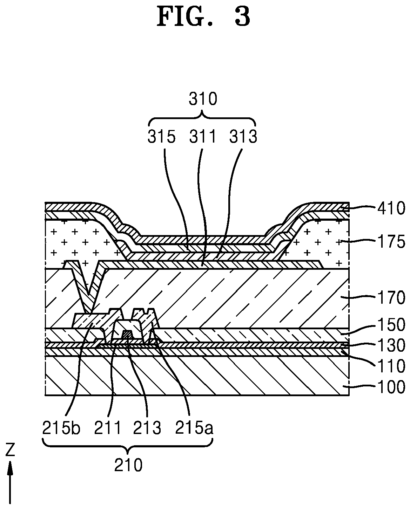

FIGS. 3 to 5 are schematic cross-sectional views showing a process of manufacturing the display apparatus of FIG. 1.

First, as shown in FIG. 3, a thin-film transistor 210 and an organic light-emitting device 310 electrically connected thereto are formed over a substrate 100. The specific configurations of the thin-film transistor 210 and the organic light-emitting device 310 are the same as described above.

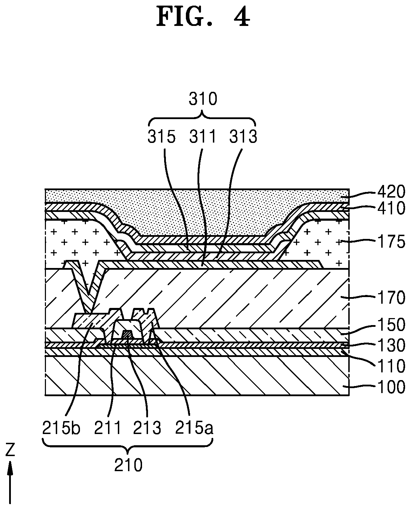

Next, as shown in FIG. 4, a first inorganic encapsulation layer 410 including silicon oxynitride, which covers the organic light-emitting device 310, is formed using a chemical vapor deposition method, and an organic encapsulation layer 420 including organic material is formed on the first inorganic encapsulation layer 410. Forming the organic encapsulation layer 420 may include forming a monomer layer for the organic encapsulation layer 420 on the first inorganic encapsulation layer 410 and then transforming the monomer layer into a polymer layer through, for example, irradiating ultraviolet rays to the monomer layer. The upper surface of the organic encapsulation layer 420 may be substantially flat.

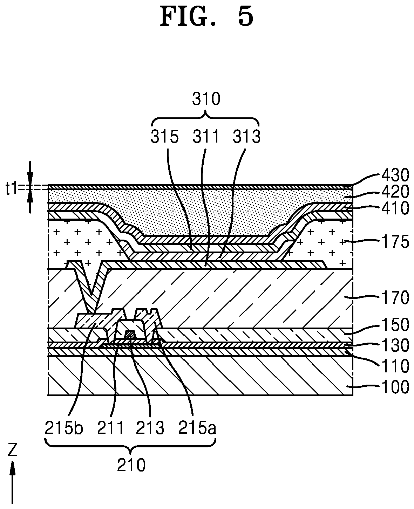

Thereafter, as shown in FIG. 5, a second inorganic encapsulation layer 430 is formed on the organic encapsulation layer 420 to a thickness of about 400 Å to about 1800 Å. Before forming the second inorganic encapsulation layer 430, the upper surface of the organic encapsulation layer 420 may be plasma-treated. This may be understood as ashing the upper surface of the organic encapsulation layer 420. Through the surface treatment, impurities on the upper surface of the organic encapsulation layer 420 may be removed, and the surface of the organic encapsulation layer 420 may be reformed. Through the reformation, the surface of the organic encapsulation layer 420 may be changed from hydrophobic to hydrophilic, and thus, when forming the second inorganic encapsulation layer 430 on the organic encapsulation layer 420 which is reformed, a bonding force between the organic encapsulation layer 420 and the second inorganic encapsulation layer 430 may be increased to facilitate the formation of the second inorganic encapsulation layer 430.

The second inorganic encapsulation layer 430 may also be formed using a chemical vapor deposition method, but when process conditions of a general chemical vapor deposition method are maintained, the organic encapsulation layer 420 may be damaged. Considering this, when forming the second inorganic encapsulation layer 430, a low power chemical vapor deposition method with a lower temperature than the case of the process conditions of the general chemical vapor deposition method is used. The thickness of the second inorganic encapsulation layer 430 is set to be about 400 Å to about 1800 Å, and may be set to be about 800 Å to about 1500 Å or may be set to be about 1000 Å to about 1200 Å as described above.

When forming the second inorganic encapsulation layer 430 in this way, reaction gases may be reaction gases for forming silicon nitride. In this case, oxygen contained in the outgas from the organic encapsulation layer 420 may be included in the second inorganic encapsulation layer 430, and as a result, the second inorganic encapsulation layer 430 contains silicon oxynitride. Accordingly, the average content of oxygen atoms in the entire second inorganic encapsulation layer 430 may be less than the average content of oxygen atoms in the entire first inorganic encapsulation layer 410. The average content of oxygen atoms in the entire second inorganic encapsulation layer 430 formed in this way may be about 5.0 atomic percent (at%) or about 7.0 atomic percent (at%). In addition, the refractive index of the second inorganic encapsulation layer 430 may be about 1.86 to about 1.89, which may be less than or equal to the refractive index of a third inorganic encapsulation layer 440 to be formed later.

After forming the second inorganic encapsulation layer 430 in this way, the third inorganic encapsulation layer 440 may be formed on the second inorganic encapsulation layer 430 by using a general chemical vapor deposition method. The third inorganic encapsulation layer 440 may include silicon nitride. When forming the third inorganic encapsulation layer 440, the sum t3 of a thickness t1 of the second inorganic encapsulation layer 430 and a thickness t2 of the third inorganic encapsulation layer 440 may be set to be about 4000 Å to about 6000 Å.

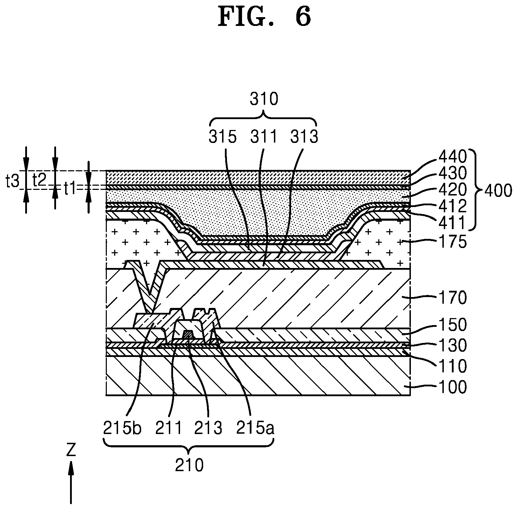

So far, the case where the first inorganic encapsulation layer 410 is a single layer has been described, but the disclosure is not limited thereto. For example, as shown in FIG. 6, which is a schematic cross-sectional view showing a display apparatus according to an embodiment, the first inorganic encapsulation layer 410 may include a 1st-1st inorganic encapsulation layer 411 and a 1st-2nd inorganic encapsulation layer 412.

The 1st-1st inorganic encapsulation layer 411 formed by chemical vapor deposition may cover the organic light-emitting device 310. The 1st-1st inorganic encapsulation layer 411 may include silicon oxynitride. The 1st-1st inorganic encapsulation layer 411 has a lower ability to prevent penetration of moisture, etc. than the third inorganic encapsulation layer 440, but has a lower refractive index than the third inorganic encapsulation layer 440, and thus, the extraction rate of light emitted from the organic light-emitting device 310 to the outside may be increased.

The 1st-2nd inorganic encapsulation layer 412 may also be formed by chemical vapor deposition and may be disposed on the 1st-1st inorganic encapsulation layer 411. The 1st-2nd inorganic encapsulation layer 412 may also include silicon oxynitride like the 1st-1st inorganic encapsulation layer 411, but the average content of oxygen atoms in the entire 1st-2nd inorganic encapsulation layer 412 may be greater than the average content of oxygen atoms in the entire 1st-1st inorganic encapsulation layer 411. For reference, for the same reason as described above with reference to FIG. 1, the average content of oxygen atoms in the entire second inorganic encapsulation layer 430 may be less than the average content of oxygen atoms in the entire 1st-1st inorganic encapsulation layer 411.

The organic encapsulation layer 420 is formed on the 1st-2nd inorganic encapsulation layer 412, and thus, in a process of manufacturing the display apparatus, a monomer for forming the organic encapsulation layer 420 may be formed on the 1st-2nd inorganic encapsulation layer 412, and then ultraviolet rays, etc. may be irradiated to transform the monomer to a polymer. In this process, when the monomer for forming the organic encapsulation layer 420 is placed on the 1st-2nd inorganic encapsulation layer 412, it is necessary to ensure that the monomer for forming the organic encapsulation layer 420 spreads well in the 1st-2nd inorganic encapsulation layer 412. When the monomer for forming the organic encapsulation layer 420 does not spread well, the organic encapsulation layer 420 may not be properly formed at the edge of the display apparatus, or the flatness of the upper surface of the organic encapsulation layer 420 may be lowered. This may be to increase the reflow characteristics of the monomer. To this end, it is desirable for the 1st-2nd inorganic encapsulation layer 412 to have hydrophilic properties, and this may be achieved by increasing the average content of oxygen atoms in the entire 1st-2nd inorganic encapsulation layer 412. In other words, it may be said that the hydrophilicity of the 1st-2nd inorganic encapsulation layer 412 is higher than the hydrophilicity of the 1st-1st inorganic encapsulation layer 411.

For example, in the case of the 1st-1st inorganic encapsulation layer 411, the ratio of the average content of silicon atoms, the average content of oxygen atoms, and the average content of nitrogen atoms in the entire 1st-1st inorganic encapsulation layer 411 may be approximately 46:34:20. In the case of the 1st-2nd inorganic encapsulation layer 412, the ratio of the average content of silicon atoms, the average content of oxygen atoms, and the average content of nitrogen atoms in the entire 1st-2nd inorganic encapsulation layer 412 may be approximately 40:54:6 (atomic percent (at%) basis). For reference, a silicon oxynitride layer may be formed by chemical vapor deposition using, for example, SiH₄ gas, N₂O gas, and NH₃ gas, and the composition ratio of the silicon oxynitride layer may be adjusted by changing the flow rate of the gases.

As described above, the 1st-2nd inorganic encapsulation layer 412 is intended to allow the monomer for forming the organic encapsulation layer 420 to spread well, and therefore does not need to be thick. Therefore, the thickness of the 1 st-2nd inorganic encapsulation layer 412 may be smaller than the thickness of the 1st-1st inorganic encapsulation layer 411. For example, the thickness of the 1st-1 st inorganic encapsulation layer 411 may be approximately 1.1 µm, and the thickness of the 1st-2nd inorganic encapsulation layer 412 may be approximately 700 Å.

According to an embodiment of the disclosure as described above, a display apparatus with a low defect rate during a manufacturing process and a method of manufacturing the display apparatus may be implemented. However, the scope of the disclosure is not limited by these effects.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus comprising:
a substrate;
an organic light-emitting device disposed over the substrate:
a first inorganic encapsulation layer covering the organic light-emitting device;
an organic encapsulation layer on the first inorganic encapsulation layer;
a second inorganic encapsulation layer on the organic encapsulation layer; and
a third inorganic encapsulation layer on the second inorganic encapsulation layer,
wherein the third inorganic encapsulation layer is thicker than the second inorganic encapsulation layer, and the second inorganic encapsulation layer has a thickness of about 400 Å to about 1800 Å.

2. The display apparatus of claim 1, wherein a sum of a thickness of the second inorganic encapsulation layer and a thickness of the third inorganic encapsulation layer is about 4000 Å to about 6000 Å.

3. The display apparatus of claim 1 or claim 2, wherein:
(i) the second inorganic encapsulation layer has a thickness of about 800 Å to about 1500 Å; or
(ii) the second inorganic encapsulation layer has a thickness of about 1000 Å to about 1200 Å.

4. The display apparatus of any one of claims 1 to 3, wherein the first inorganic encapsulation layer includes silicon oxynitride, the second inorganic encapsulation layer includes silicon oxynitride, and the third inorganic encapsulation layer includes silicon nitride.

5. The display apparatus of claim 4, wherein an average content of oxygen atoms in the entire second inorganic encapsulation layer is about 5.0 atomic percent (at%) to about 7.0 atomic percent (at%).

6. The display apparatus of claim 4 or claim 5, wherein a refractive index of the second inorganic encapsulation layer is about 1.86 to about 1.89, optionally wherein a refractive index of the third inorganic encapsulation layer is greater than the refractive index of the second inorganic encapsulation layer.

7. The display apparatus of any one of claims 4 to 6, wherein an average content of oxygen atoms in the entire first inorganic encapsulation layer is higher than an average content of oxygen atoms in the entire second inorganic encapsulation layer.

8. The display apparatus of any one of claims 1 to 7, wherein the first inorganic encapsulation layer includes:
a 1st-1st inorganic encapsulation layer covering the organic light-emitting device and including silicon oxynitride; and
a 1st-2nd inorganic encapsulation layer disposed on the 1st-1st inorganic encapsulation layer and including silicon oxynitride,
wherein an average content of oxygen atoms in the entire 1st-2nd inorganic encapsulation layer is higher than an average content of oxygen atoms in the entire 1st-1st inorganic encapsulation layer, optionally wherein the 1st-2nd inorganic encapsulation layer is thinner than the 1st-1st inorganic encapsulation layer.

9. A method of manufacturing a display apparatus, the method comprising:
forming an organic light-emitting device over a substrate;
forming a first inorganic encapsulation layer covering the organic light-emitting device;
forming an organic encapsulation layer on the first inorganic encapsulation layer;
forming a second inorganic encapsulation layer with a thickness of about 400 Å to about 1800 Å on the organic encapsulation layer; and
forming a third inorganic encapsulation layer on the second inorganic encapsulation layer, the third inorganic encapsulation layer being thicker than the second inorganic encapsulation layer.

10. The method of claim 9, wherein:
(i) the method further comprises, between the forming of the organic encapsulation layer and the forming of the second inorganic encapsulation layer, surface-treating an upper surface of the organic encapsulation layer by using plasma; and/or
(ii) the forming of the third inorganic encapsulation layer includes forming the third inorganic encapsulation layer so that the sum of a thickness of the second inorganic encapsulation layer and a thickness of the third inorganic encapsulation layer is about 4000 Å to about 6000 Å.

11. The method of claim 9 or claim 10, wherein:
(i) the forming of the second inorganic encapsulation layer includes forming the second inorganic encapsulation layer to a thickness of about 800 Å to about 1500 Å; or
(ii) the forming of the second inorganic encapsulation layer includes forming the second inorganic encapsulation layer to a thickness of about 1000 Å to about 1200 Å.

12. The method of any one of claims 9 to 11, wherein the forming of the first inorganic encapsulation layer includes forming an inorganic encapsulation layer including silicon oxynitride, the forming of the second inorganic encapsulation layer includes forming an inorganic encapsulation layer using reaction gases which do not include an oxygen source, and the forming of the third inorganic encapsulation layer includes forming an inorganic encapsulation layer including silicon nitride.

13. The method of claim 12, wherein:
(i) an average content of oxygen atoms in the entire second inorganic encapsulation layer is about 5.0 atomic percent (at%) to about 7.0 atomic percent (at%); and/or
(ii) a refractive index of the second inorganic encapsulation layer is about 1.86 to about 1.89, optionally wherein a refractive index of the third inorganic encapsulation layer is greater than the refractive index of the second inorganic encapsulation layer.

14. The method of claim 12 or claim 13, wherein an average content of oxygen atoms in the entire first inorganic encapsulation layer is higher than an average content of oxygen atoms in the entire second inorganic encapsulation layer.

15. The method of any one of claims 9 to 14, wherein the forming of the first inorganic encapsulation layer includes:
forming a 1st-1st inorganic encapsulation layer including silicon oxynitride to cover the organic light-emitting device; and
forming a 1st-2nd inorganic encapsulation layer including silicon oxynitride on the 1st-1st inorganic encapsulation layer,
wherein an average content of oxygen atoms in the entire 1st-2nd inorganic encapsulation layer is higher than an average content of oxygen atoms in the entire 1st-1st inorganic encapsulation layer, optionally wherein the 1st-2nd inorganic encapsulation layer is thinner than the 1st-1st inorganic encapsulation layer.
